# EUROPÄISCHE PATENTSCHRIFT

(11) **EP 3 368 890 B1**
(45) Veröffentlichungstag und Bekanntmachung des Hinweises auf die Patenterteilung: **04.06.2025**
(21) Anmeldenummer: 16801705.1
(22) Anmeldetag: 28.10.2016
(51) Int. Cl.: G01N 27/72

(54) **VERFAHREN UND VORRICHTUNG ZUM BEOBACHTEN EINES MAGNETFELDS EINES MATERIALVOLUMENS SOWIE VERWENDUNG DER VORRICHTUNG**
METHOD AND APPARATUS FOR MONITORING A MAGNETIC FIELD OF A MATERIAL VOLUME AND USE OF THE APPARATUS
METHODE ET APPAREIL DE SURVEILLANCE D'UN CHAMP MAGNETIQUE D'UN VOLUME DE MATERIAU ET UTILISATION DE L'APPAREIL

(30) Priorität: 28.10.2015 DE 202015007470 U; 26.10.2016 DE 202016006620 U
(43) Veröffentlichungstag der Anmeldung: 05.09.2018
(73) Patentinhaber: Qass GmbH, 58300 Wetter (DE)
(72) Erfinder: SEUTHE, Ulrich, 58300 Wetter (DE)
(74) Vertreter: Grosse Schumacher Knauer von Hirschhausen
(86) Internationale Anmeldenummer: PCT/EP2016/001792
(87) Internationale Veröffentlichungsnummer: WO 2017/071812

(56) Entgegenhaltungen:
- EP-A2- 0 918 999
- ANTRIEBSTECHNICK E.V. FORSCHUNGSVEREINIGUNG: "Verfahrensanweisung Barkhausen", 11 February 2010 (2010-02-11), XP055599909, Retrieved from the Internet <URL:https://web.archive.org/web/20160407050028if_/http://de.stresstechgroup.com/files/upload_pdf/1076577/Verfahrensanweisung%20Barkhausen%20Stand%202010%2002%2011_V1.pdf> [retrieved on 20190626]
- WANG YUJUE ET AL: "Quantitative Evaluation of the Effect of Temperature on Magnetic Barkhausen Noise", SENSORS, vol. 21, no. 3, 29 January 2021 (2021-01-29), pages 898, XP055800130, DOI: 10.3390/s21030898
- AUGUSTYNIAK B ET AL: "New approach to hysteresis process investigation using mechanical and magnetic Barkhausen effects", JOURNAL OF MAGNETISM AND MAGNETIC MATERIALS, vol. 140, 28 February 1995 (1995-02-28), pages 1837 - 1838, XP085547686, ISSN: 0304-8853, DOI: 10.1016/0304-8853(94)01603-8
- PIOTROWSKI L ET AL: "An In-Depth Study of the Barkhausen Emission Signal Properties of the Plastically Deformed Fe-2%Si Alloy", IEEE TRANSACTIONS ON MAGNETICS, IEEE SERVICE CENTER, NEW YORK, NY, US, vol. 44, no. 11, 1 November 2008 (2008-11-01), pages 3828 - 3831, XP011240254, ISSN: 0018-9464, DOI: 10.1109/TMAG.2008.2002634
- L R PADOVESE ET AL: "Time-frequency and time-scale analysis of Barkhausen noise signals", PROCEEDINGS OF THE INSTITUTION OF MECHANICAL ENGINEERS, PART G: JOURNAL OF AEROSPACE ENGINEERING, vol. 2007, no. 5, 30 April 2009 (2009-04-30), United Kingdom, pages 9 - 588, XP055338241, ISSN: 0954-4100, DOI: 10.1243/09544100JAERO436
- FRANCO F A ET AL: "NDT flaw mapping of steel surfaces by continuous magnetic Barkhausen noise: Volumetric flaw detection case", NDT & E INTERNATIONAL, BUTTERWORTH-HEINEMANN, OXFORD, GB, vol. 42, no. 8, 1 December 2009 (2009-12-01), pages 721 - 728, XP026546633, ISSN: 0963-8695, [retrieved on 20090621], DOI: 10.1016/J.NDTEINT.2009.06.007
- HOSSEINI SALEH ET AL: "Application of time-frequency analysis for automatic hidden corrosion detection in a multilayer aluminum structure using pulsed eddy cur", NDT & E INTERNATIONAL, vol. 47, 27 December 2011 (2011-12-27), pages 70 - 79, XP028898670, ISSN: 0963-8695, DOI: 10.1016/J.NDTEINT.2011.12.001
- CAPO-SANCHEZ J ET AL: "Magnetic Barkhausen noise measurement by resonant coil method", JOURNAL OF MAGNETISM AND MAGNETIC MATERIALS, ELSEVIER, AMSTERDAM, NL, vol. 321, no. 18, 1 September 2009 (2009-09-01), pages L57 - L62, XP026156541, ISSN: 0304-8853, [retrieved on 20090401], DOI: 10.1016/J.JMMM.2009.03.070
- S BARTELDES ET AL: "Residual stress evolution and acoustic emission during lubrication- assisted White Etching Crack (WEC) Formation", 2014 STLE ANNUAL MEETING & EXHIBITION MAY 18-22, 2014 DISNEY'S CONTEMPORARY RESORT LAKE BUENA VISTA, FLORIDA, USA, 22 May 2014 (2014-05-22), XP055338665
- R RANJAN ET AL: "Grain size measurement using magnetic and acoustic Barkhausen noise", J. APP. PHYSICS, vol. 61, 15 April 1987 (1987-04-15), pages 3199 - 3201, XP055338861, Retrieved from the Internet <URL:http://lib.dr.iastate.edu/cgi/viewcontent.cgi?article=1005&context=ameslab_pubs> [retrieved on 20170125]

## Beschreibung

### Gebiet der Erfindung

Die Erfindung betrifft ein Verfahren und eine Vorrichtung zum Beobachten eines Magnetfelds eines Materialvolumens sowie die Verwendung der Vorrichtung nach dem Oberbegriff des Anspruchs 1, 10 bzw. 13.

### Hintergrund der Erfindung

Zur Beobachtung eines Magnetfelds eines Materialvolumens zwecks Bestimmung der Eigenschaften eines Werkstücks werden Induktivitäten oder Hall-Sensoren oder dergleichen verwendet. Dabei wird die zeitliche Veränderung des Magnetfelds in Reaktion auf eine magnetische Anregung erfasst. Aus der zeitlichen Veränderung des resultierenden Magnetfelds können Rückschlüsse auf die Eigenschaften des Werkstücks gezogen werden.

Die aus dem Stand der Technik bekannten Verfahren und Vorrichtungen stellen dabei auf makromagnetische Effekte als Funktion der Zeit ab.

Beispielsweise ist es aus der US 4634976 A bekannt, Materialfehler durch magentische Anregung eines Werkstücks unter Auswertung des Barkhausen-Rauschens zu erkennen. Vergleichbarer Stand der Technik ist aus der US 4977373 A und der US 20130276546 A1 bekannt.

Bei den obengenannten Verfahren werden die makromagnetischen Effekte nur im Amplituden-Zeit-Bereich erfasst und ausgewertet.

Aus PIOTROWSKI L ET AL: "An In-Depth Study of the Barkhausen Emission Signal Properties of the Plastically Deformed Fe-2%Si Alloy", IEEE TRANSACTIONS ON MAG-NETICS, Bd. 44, Nr. 11, (2008-11-01), Seiten 3828 - 3831, ISSN: 0018-9464, DOI: 10.1109/TMAG.2008.2002634 ist es bekannt, ein in einer Abschirmung angeordnetes Materialvolumen eines Werkstücks mit einem magnetischen Wechselfeld anzuregen. Dabei wird eine zeitaufgelöste FFT Analyse des Barkhausen-Signals und der Verteilung der Pulse durchgeführt.

L R PADOVESE ET AL: "Time-frequency and time-scale analysis of Barkhausen noise signals", PROCEEDINGS OF THE INSTITUTION OF MECHANICAL ENGINEERS, PART G: JOURNAL OF AEROSPACE ENGINEERING, Bd. 2007, Nr. 5, (2009-04-30), Seiten 577 - 588, ISSN: 0954-4100, DOI: 10.1243/09544100JAERO436 beschreibt eine Zeit-Frequenz-Analyse von Barkhausen-Rauschsignalen unter Magnetisierung eines Materialmusters.

Allen bekannten Verfahren und Vorrichtungen haftet der Nachteil an, dass das Werkstück nur unzureichend bewertet werden kann.

### Zusammenfassung der Erfindung

Ausgehend hiervon liegt der Erfindung die Aufgabe zugrunde, ein Verfahren und eine Vorrichtung zum Beobachten eines Magnetfelds eines Materialvolumens sowie die Verwendung der Vorrichtung nach dem Oberbegriff des Anspruchs 1, 10 bzw. 13 zu schaffen, die präziser sind.

Diese Aufgabe wird entsprechend den Merkmalen des Anspruchs 1, 10 bzw. 13 gelöst.

Demnach wird ein Verfahren zum Beobachten eines Magnetfelds eines Materialvolumens, insbesondere zur Bestimmung von Eigenschaften eines Werkstücks unter mechanischer und/oder thermischer Anregung oder dergleichen eines Materialvolumens des Werkstücks, geschaffen, bei dem das Magnetfeld des Materialvolumens als Funktion der Zeit und der Frequenz mit einer hochfrequenten Auflösung erfasst wird. Durch die hochfrequente Auflösung in der Zeit- und/oder Frequenzachse ist eine präzise Erfassung mikromagnetischer Effekte möglich, die präzisere qualitative Rückschlüsse auf die Materialeigenschaften erlauben.

Vorzugsweise wird die mikromagnetische Reaktion auf die Anregung erfasst.

Ferner kann die Geschwindigkeit der Reaktion auf die Anregung erfasst werden.

Die Frequenz- und/oder Zeitauflösung der Anregung und/oder der Erfassung wird bevorzugt entsprechend der mikromagnetischen Effekte im Materialvolumen gewählt.

Die Anregung kann mit einem magnetischen und/oder elektrischen Wechselfeld und/oder statischem Feld und/oder mittels Wirbelstrominduktion und/oder durch eine Materialverarbeitung wie etwa Induktionshärten und/oder durch Anlegen eines Wechsel- oder Gleichstroms und/oder Anlegen einer Wechsel- und/oder Gleichspannung erfolgen.

Das Material kann bei der Anregung und/oder dem Erfassen relativ zu einem Sensor und/oder einer Anregevorrichtung ortsfest sein oder relativ zu einem Sensor und/oder einer Anregevorrichtung verfahren werden.

Die Frequenz der anregenden Quelle kann variiert werden, insbesondere kann ein Frequenzbereich durchfahren werden.

Mehrere Anregevorrichtungen und/oder mehrere Magnetfeldsensoren können verwendet werden.

Die Erfindung schafft ferner eine Vorrichtung zum Beobachten eines Magnetfelds eines Materialvolumens, insbesondere zur Bestimmung von Eigenschaften eines Werkstücks unter mechanischer und/oder thermischer Anregung eines Materialvolumens des Werkstücks, wobei ein Sensor zum Erfassen des Magnetfelds des Materialvolumens als Funktion der Zeit und der Frequenz mit einer hochfrequenten Auflösung vorgesehen ist.

Vorzugsweise ist eine Anregevorrichtung zur elektrischen und/oder magnetischen Anregung eines Materialvolumens des Werkstücks vorgesehen.

Die Erfindung schafft, betrifft und/oder ermöglicht ferner:
- Erkennen von Rissen in ferritischen Materialien
- Erkennung von Lunkern oder Fremdmaterialeinschlüssen in ferritischen Materialien
- Bewertung der Kristallbildung beim Abkühlen ferritischer Materialien
- Anlegen einer Magnetisierungskarte eines Bauteiles
- Vergleich der Magnetisierungskarte eines Musterbauteiles mit anderen Bauteilen zur Qualitätsbewertung
- Erkennung von Härtefehlern oder Härteveränderungen in Materialien
- Erkennung der Einhärtetiefe und des Härtegradienten an ferritischen Materialien
- Erkennen der Korn- bzw. Kristallitstruktur in Eisen- und anderen ferritischen Werkstoffen
- Erzeugung der Magnetisierung ferritischer Werkstoffe durch ein magnetisches Wechselfeld, das in seinem zeitlichen Verlauf auf eine gleichmäßige Umorientierungsfolge der einzelnen Weissschen Bezirke hin optimiert ist
- Erzeugung der Magnetisierung durch Vorbeiführen des Werkstoffes an einem statischen Magnetfeld, so dass alle Kristallite denselben Gradienten eines äußeren Magnetfeldes erfahren
- Kalibrierung einer schnellen Messung der Magnetisierung ferritischer Materialien mit einer langsameren zeitlich hochaufgelösten Messung zur Erfassung
- Beschreibung des Magnetisierungsverhaltens eines Materialvolumens nach einer einzigen Magnetisierung
- Beschreibung der mechanischen Eigenschaften eines Materialvolumens nach einer einzigen Magnetisierung
- Beschreibung des Magnetisierungsverhaltens eines Materialvolumens ohne die magnetische Sättigung im gesamten Volumen erreicht zu haben
- Bestimmung von Legierungsbestandteilen ferritischer Materialen anhand der Magnetisierungseigenschaften einzelner Kristallite
- Anwendung einer Kombination aus Kurzzeit FFTs und deren zeitliche Auswertung zur Analyse der Magnetisierungseigenschaften aller in einem Materialvolumen befindlichen Weissschen Bezirke
- Anwendung einer Kombination aus Kurzzeit FFTs und deren zeitliche Auswertung zur Analyse der Magnetisierungseigenschaften aller in einem Materialvolumen befindlichen Weissschen Bezirke, die zu bestimmten Gruppen geordnet nach Größe und Lage im äußeren Magnetfeld, zusammengefasst werden
- Anwendung einer Kombination aus Kurzzeit FFTs und deren zeitliche Auswertung zur Erzeugung einer Magnetisierungskarte eines Materialbereiches oder eines Bauteiles

### Figurenbeschreibung

Fig. 1 illustriert eine Erfassung des zeitlichen Magnetfeldverlauf nach einer magnetischen Anregung gemäß Stand der Technik.
Fig. 2 illustriert eine mehrdimensionale Erfassung des Magnetfeldverlaufs im Frequenz-Zeit-Diagramm.
Fig. 3 zeigt die Hauptemissionen aus Fig. 2 mit Frequenz-, Zeit- und Amplitudenverlauf.
Fig. 4 zeigt die Hauptemissionen aus Fig. 3 mit Projektion auf die Zeitachse.
Fig. 5 zeigt die Hauptemissionen aus Fig. 3 mit Projektion auf die Frequenzachse.
Fig. 6 bis 9 zeigen weitere Ausführungsformen.

### Beschreibung der Ausführungsformen

### Analyse von Magnetfeldern

Es werden Schwankungen von Magnetfeldern analysiert.

Die Felder werden mit geeigneten Sensoren, Induktivitäten, Hall Sensor etc. gemessen. Die Frequenzbandbreite der Sensoren sollte möglichst hoch sein. Bevorzugt wird eine Frequenz bis zu 1 MHz, 3 MHz, 50 MhZ, 100 MHz, 1 GHz, 10 GHz. Die obere Grenzfrequenz korreliert mit der qualitativen Auflösung, d.h. je höher die Grenzfrequenz, desto kleinere magnetische Strukturen können erfasst werden. Im GHz-Bereich kann die Änderung der magnetischen Felds einzelner Dipole erfasst werden. Insofern besteht eine Korrelation zwischen der oberen Grenzfrequenz und der Kristallitstruktur des Materials.

Die Messsignale werden vorzugsweise vielen Kurzzeit FFTs unterzogen, so dass die breitbandige Frequenzabhängigkeit in jedem Zeitpunkt und auch in ihrer zeitlichen Abfolge beschrieben werden kann.

Weitere Transformationen, die die zeitlichen und quantitativen Magnetfeldänderungen im Detail beschreiben sind denkbar. Ein Algorithmus zur Impulsanalyse erzeugt die benötigten Informationen.

Zweckmäßigerweise werden rund 64 Millionen Messwerte für eine Messung ausgewertet. Aber auch die 10 fach höhere Datenmenge kann interessant sein.

### Analyse der Mikrostruktur von Eisenwerkstoffen

Eisen bildet als ferromagnetisches Material magnetische Dipole in jedem Weisschen Bezirk aus.

Diese Dipole können durch Anlegen eines äußeren Magnetfeldes in dessen Richtung umorientiert werden. Mit dem Einschwenken der Mikrodipole auf die Richtung des äußeren Magnetfeldes, wird dessen Stärke erhöht bis schließlich alle Mikrodipole in Richtung des äußeren Feldes liegen.

Zur Überwindung des im Mikrodipol vorliegenden Magnetmomentes ist eine gewisse entgegengerichtete magnetische Feldstärke notwendig. Die der Feldquelle am nächsten liegenden Dipole erfahren die größte Kraft. Je mehr Mikrodipole umorientiert sind, umso größer wird die resultierende Feldstärke in Richtung des äußeren Feldes.

Damit können auch weiter entfernte Mikrodipole umorientiert werden.

Die Änderung des Magnetfeldes erzeugt einen elektrischen Strom, dessen Änderung ein entgegengesetztes Magnetfeld erzeugt. Je größer die Änderungsgeschwindigkeit des äußeren Magnetfeldes ist, umso größer ist auch die induzierte Gegenkraft, was die Umorientierung der Mikrodipole in größerer Entfernung verlangsamt.

Mit einer sehr empfindlichen Messung der Magnetfeldänderungen können die Effekte der Umorientierung der Mikrodipole aufgelöst werden.

Durch eine Begrenzung des äußeren Magnetfeldes auf ein bestimmtes Materialvolumen können dann Aussagen über die Struktur und die Eigenschaften dieses Materialvolumens getroffen werden. Die Effekte, die durch weiter entfernte Strukturen ausgelöst werden, können aufgrund ihrer geringen Anzahl vernachlässigt werden. Da die Weissschen Bezirke, d.h. die Materialvolumina die jeweils eine einheitliche Orientierung der FE-Elektronenspins aufweisen und damit magnetische Mikrodipole darstellen, gleichzeitig auch mechanisch interessante Eigenschaften aufweisen, kann von den magnetischen Eigenschaften auf einige mechanische Eigenschaften geschlossen werden.

Die Größenverteilungen von Mikrokristallen im Eisenwerkstoff beschreiben auch Zug- und Druckfestigkeiten.

Wenn die genaue Größe und räumliche Ausdehnung der Eisenkristallite bekannt ist, können präzise Aussagen über die mechanischen Eigenschaften des Materials getroffen werden.

Absichtlich oder unabsichtlich in das Eisen eingebrachte Elemente verändern die mechanischen, die elektrischen und auch die magnetischen Eigenschaften des Materials.

Kohlenstoffhaltige Stähle finden eine breite Anwendung wenn gehärtete Eisenwerkstoffe eingesetzt werden sollen. Die konkrete Verteilung des Kohlenstoffs im Eisen, die Größenverteilungen der Kristallite, die vollständige oder unvollständige Einlagerung aller verfügbaren Kohlenstoffatome in Eisengittern, das Vorhandensein elementaren Kohlenstoffs im Werkstoff usw. wirken sich auf die Eigenschaften des Materials aus.

Ähnliches gilt für weitere wichtige Legierungselemente oder Störelemente, die unabsichtlich in das Material gelangen.

Zur Analyse werden viele verschieden Methoden angewendet.

Druck- und Zugprüfungen definierter Querschnitte oder Flächen sowie Belastungsprüfungen fertiger Bauteile.

Mikroskopierungen von Materialproben zur Beschreibung der Kristallstrukturen und der Einlagerungen verschiedener Legierungsbestandteile.

Röntgen-, Wirbelstrommessungen als Beispiele für nicht zerstörende Untersuchungen.

Bekannt ist das Anlegen von magnetischen Wechselfeldern und die Ermittlung einzelner magnetischer Kennwerte beim wiederholten Durchlaufen magnetischer Hysteresekurven, also beim wiederholten Umpolen eines äußeren Magnetfeldes. Die Kennwerte werden als Durchschnittswerte eingeschwungener Zustände ermittelt.

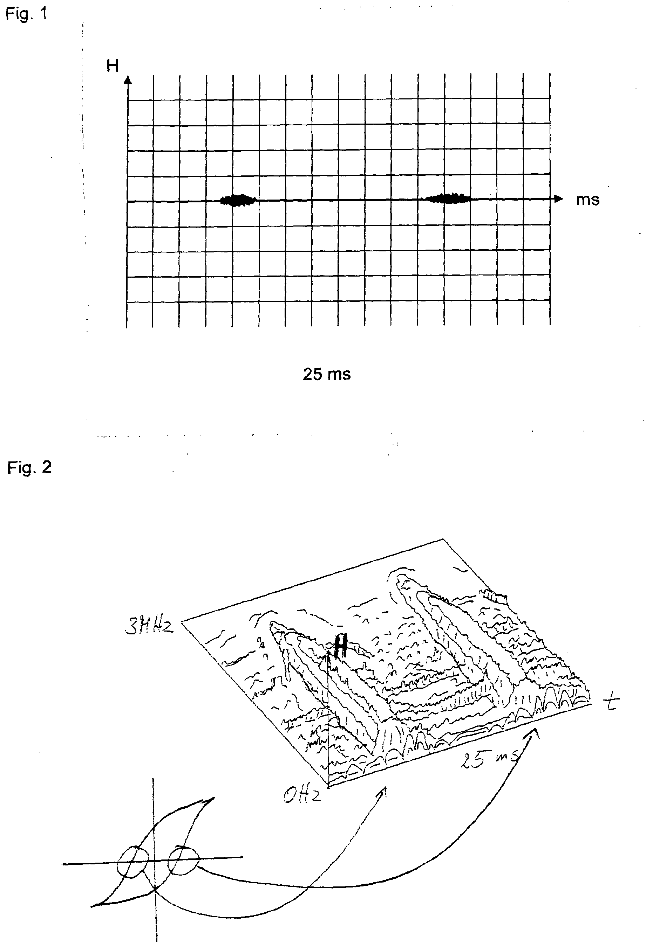

Ebenfalls aus dem Stand der Technik bekannt ist die Auswertung vorzugsweise auf der Amplituden-, Zeit- und Frequenzverteilung einer einzigen Magnetisierung. Bereits das Durchlaufen einer Hälfte einer Hysteresekurve liefert bei der Frequenz-Zeit-Analyse Informationen über das untersuchte Material. Wird die Hysteresekurve vollständig durchlaufen, siehe Fig. 2 am Beispiel einer sinusförmigen magnetischen Anregung, oder werden mehrere Durchläufe erfasst, steigt die Aussagewahrscheinlichkeit der Messergebnisse.

Die Anregung kann dergestalt optimiert werden, dass die Hysteresekurve möglichst flach ist. Dadurch dauert der Magnetisierungsvorgang länger und ist aussagekräftiger. Die Erregungskurve kann dabei materialangepasst optimiert werden.

Die Aussagewahrscheinlichkeit der Messergebnisse kann durch Wiederholungen erhöht werden, hierbei geht es aber um die Reduzierung des Messfehlers.

Wie aus dem Stand der Technik bekannt, kann die Frequenzverteilung der Magnetfeldänderung und die den Frequenzen zugehörigen Amplitudensprünge analysiert und daraus die Größenverteilung der Weissschen Bezirke ermittelt werden.

Wenn die Abtastgeschwindigkeit der Magnetfeldänderungen größer ist als die mittlere Geschwindigkeit der Umorientierung der einzelnen Weissschen Bezirke, kann eine Zuordnung der einzelnen Bezirke und ihrer Größe zum Ort der magnetischen Feldstärke vorgenommen werden, da die Bezirke im Bereich höherer Feldstärken zuerst umorientiert werden.

Die magnetische Feldstärke bzw. die Änderungsgeschwindigkeit der Feldstärke kann variiert werden, um sukzessive Informationen über tieferlegende Materialschichten hinzuzufügen und damit ein Tiefenprofil der durchschnittlichen Größen der Weissschen Bezirke zu erhalten.

Damit generieren wir eine Beschreibung der Härte- und Festigkeitsprofile des Materials sowie eine Beschreibung der Verteilung von Materialstörungen, insofern sie sich auf die Ausprägung der Mikrodipole auswirken.

### Nicht erfindungsgemäßes Beispiel:

Die durchschnittliche Kristallitgröße betrage 10µm^3. Die relevante Feldgröße sei 4x8x2mm, also 64mm^3. Dann werden insgesamt ca. 64*10^6 Mikrodipole beeinflusst.

Bei einer Abtastrate von 100MHz und einer Zeit bis zur Sättigungsmagnetisierung von einer Sekunde können die Magnetfeldzuwächse der einzelnen Dipole beschrieben werden.

Die Veränderung der Orientierung der Elektronenspinachse eines einzelnen Elektrons kann nur in bestimmten Quantisierungen erfolgen.

Benachbarte Elektronen innerhalb eines Weissschen Bezirks sind magnetisch aufeinander ausgerichtet, haben also alle koordinierte Spinachsenrichtungen. Beginnt die sprunghafte Drehung der Spinachse einiger Elektronen so führt das zu einer beschleunigten Umschwenkung aller benachbarten, die ja ohnehin eine ähnliche äußere magnetische Feldstärke erfahren. Damit kommt es, wenn die Geschwindigkeit dieses Umklappvorganges maximal ist, zu einem quasi impulsartigen Anstieg des Magnetfeldes in der Größenordnung des Magnetfeldes des angeglichenen Weissschen Bezirkes bezogen auf die Richtung des äußeren Magnetfeldes. Gerade diese schnellen Veränderungen eines Weissschen Bezirkes, die sich dem gesamten Magnetfeld überlagern, werden durch unsere Auswertung erfasst.

Mit einer zunehmenden Anzahl angeglichener bzw. weitgehend angeglichener Mikrodipole wächst das resultierende Gesamtmagnetfeld immer schneller an.

Durch eine geschickte Veränderung des äußeren Magnetfeldes kann dieser Lawineneffekt, der sich dann im Verlauf der Hysteresekurve des Gesamtmagnetfeldes niederschlägt, ausgeglichen werden, so dass wir einen möglichst linearen Verlauf des Feldstärkezuwachses erzielen.

Dahinter steht die bevorzugte Absicht, bei einer gegebenen maximalen Abtastrate, eine möglichst gute Auflösung des Umklappverhaltens aller im betrachteten Volumen enthaltenen Kristallite zu erzielen.

Kristallite, die identische Raumwinkeldifferenz zwischen ihrer inneren Magnetfeldorientierung und dem äußeren Magnetfeld haben und in Bereichen identischer Feldstärke des äußeren Feldes liegen, können in ihrem Drehverhalten nicht unterschieden werden. Zusätzlich unterliegen sie noch den Wirkungen der sie umgebenden Kristallite, die ja ebenfalls das Magnetfeld insgesamt, aber auch im Mikrobereich verändern. Dennoch mag es Kristallite geben deren Verhalten nicht getrennt werden kann. Insofern erscheint es ebenfalls sinnvoll Messergebnisse zu verwenden, die nicht die volle Auflösung, sondern eher Summeneffekte der Magnetfeldänderungen beschreiben.

Dieser Ansatz kann genutzt werden, um eine Messung in deutlich kürzerer Zeit durchzuführen. Ein Kompromiss zwischen vollständiger Erfassung aller Kristalliteinflüsse und einer sehr schnellen Messung wird erzielt.

Denkbar ist auch, dass die hoch auflösende Messung mit neuen Materialen durchgeführt wird, und diese Ergebnisse dann zur Kalibrierung deutlich schnellerer aber niedriger aufgelöster Messungen genutzt wird.

Das Verfahren benötigt ein sich im Materialvolumen änderndes Magnetfeld. Dies kann z.B. durch das Anlegen eines Magnetfelds, dessen Stärke innerhalb des gewünschten Zeitraumes verändert wird, erzielt werden, und/oder indem das Material durch ein statisches Magnetfeld hindurchbewegt wird.

Sollte sich die Kristallitstruktur (z.B. aufgrund anderer Härtezustände) des Materials verändern, so schlägt sich das in einer veränderten Verteilung der Magnetfeldzuwächse nieder. Damit schafft dieses Verfahren die Möglichkeit, auch Messungen an bewegten Materialen z.B. innerhalb von Produktionsprozessen durchzuführen.

Die Messsonden können in einer Drahtzug- oder sonstigen Strangumformanlage untergebracht werden, um das Material auf seiner gesamten Länge während der Umformung auf Abweichungen hin zu analysieren und Informationen über die tatsächlichen Festigkeiten und andere mechanische Eigenschaften zu erhalten.

Durch Anwendung wiederholter Messungen können verschiedene Volumenelemente eines Materials analysiert werden, ebenso können zeitliche Veränderungen z.B. beim Abkühlen in einem Härteprozess untersucht werden.

Damit kann die Unterschreitung der Curie Temperatur und der Ablauf der Kristallisierungseffekte im Material beobachtet werden.

Die Messsonden können direkt in einem Umformwerkzeug zur Heissumformung und Härtung von Stahlblechen eingesetzt und der Vorgang der Kristallisierung und damit der Härtung kann in Situ beobachtet werden.

Neben der Analyse der Kristallitstruktur des Materials können auch makroskopische Fehler wie Risse oder Lunker detektiert werden, wenn diese sich im Bereich der Magnetfeldanalyse befinden.

Durch schnelle Messungen ermöglicht die Erfindung ein vollständiges Abtasten von Bauteiloberflächen bzw. von Bauteilschichten.

Insbesondere für randschichtgehärtete Stähle ist eine Analyse bis zur Einhärtetiefe sehr hilfreich. Gerade diese Materialbereiche werden sowohl durch den Härteprozess wie auch später in der Bauteilnutzung besonders belastet.

Für in Serie gefertigte Bauteile kann jeweils eine Magnetfeldänderungskarte erstellt werden, die sich während des Abscannens der relevanten Materialschichten ergibt. Das Verhalten jedes weiteren Bauteiles kann dann mit dieser Karte verglichen und Abweichungen unmittelbar protokolliert werden.

Das erfindungsgemäße Verfahren eignet sich z.B. zur Detektion von Neuhärtezonen in geschliffenen Oberflächen wie sie in der Lager- oder Zahnradfertigung auftreten.

### Beispiele

Fig. 1 illustriert den zeitlichen Verlauf des Magnetfelds H nach einer magnetischen Anregung durch Anlegen eines sinusförmig modulierten äußeren Magnetfelds an eine ferromagnetische Materialprobe. Dargestellt sind die AC Anteile der Änderungen des resultierenden Magnetfeldes. (Hochpass mit ca. 1000Hz Grenzfrequenz, Abtastrate 50MHz, Downsampling auf 6MHz) Die Sinusperiode liegt erkennbar bei 50Hz. Es ist ein vollständiger Durchlauf durch die Hysteresekennlinie dargestellt.

Fig. 2 ist eine Darstellung im Zeit-Frequenzbereich mit einer hochfrequenten Auflösung im Frequenzbereich, so dass mikromagnetische Effekte erkennbar sind. Neben den beiden Haupemissionsfeldern, von denen jedes einem hier magnetischen Anregungsimpuls zuzuordnen ist, sind viele typische Nebenemissionen sichtbar. Das Frequenz-Zeit-Diagramm bildet einen Fingerabdruck, aus welchem Rückschlüsse auf die mikromagnetischen Vorgänge ableitbar sind.

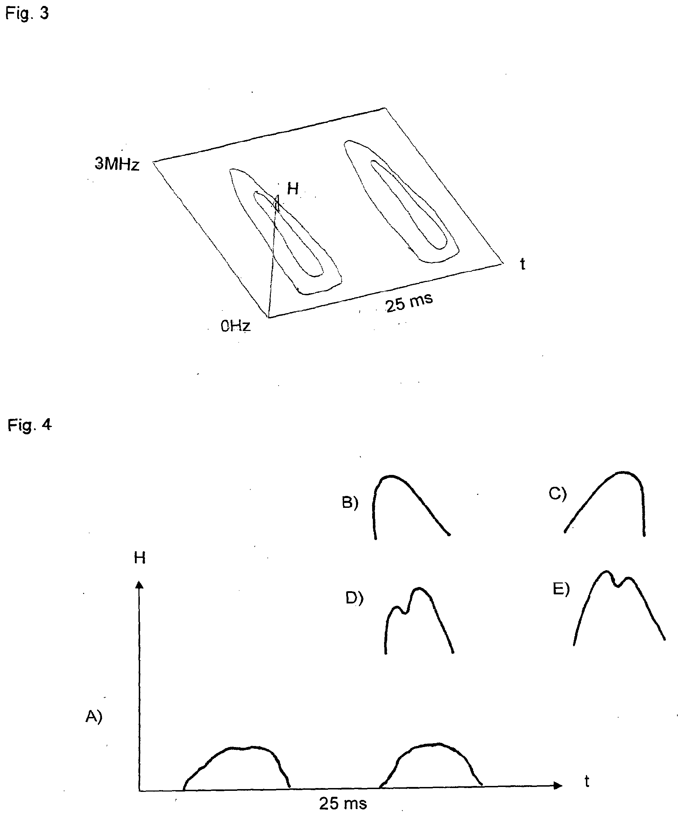

Fig. 3 zeigt die Hauptemissionen aus Fig. 2 mit Frequenz-, Zeit- und Amplitudenverlauf.

Fig. 4A zeigt die Hauptemissionen mit Projektion auf die Zeitachse. Fig. 4B bis 4D zeigen alternative Signalformen. So kann bei beliebiger, auch nicht magnetischer Anregung, aus der Signalform ein Rückschluss auf eine Materialeigenschaft erfolgen. Ob die Signalform eher steiler ansteigt als abfällt, Fig. 4B, oder flacher ansteigt als abfällt, Fig. 4C, oder eine Doppel- (Fig. 4D, 4E) oder Mehrfachschwingung aufweist, ist zur Charakterisierung von Material-, Werkzeug- oder Prozesseigenschaften aussagekräftig. Insbesondere kann aus der Signalform, ob projeziert wie in Fig. 4 oder im Schnitt der Fig. 2 oder mehrdimensional ausgewertet wie in Fig. 2, 3, Information erhalten werden betreffend die Härte des Materials, die Eigenspannung, die Gefügestruktur, Legierungsbestandteile usw.

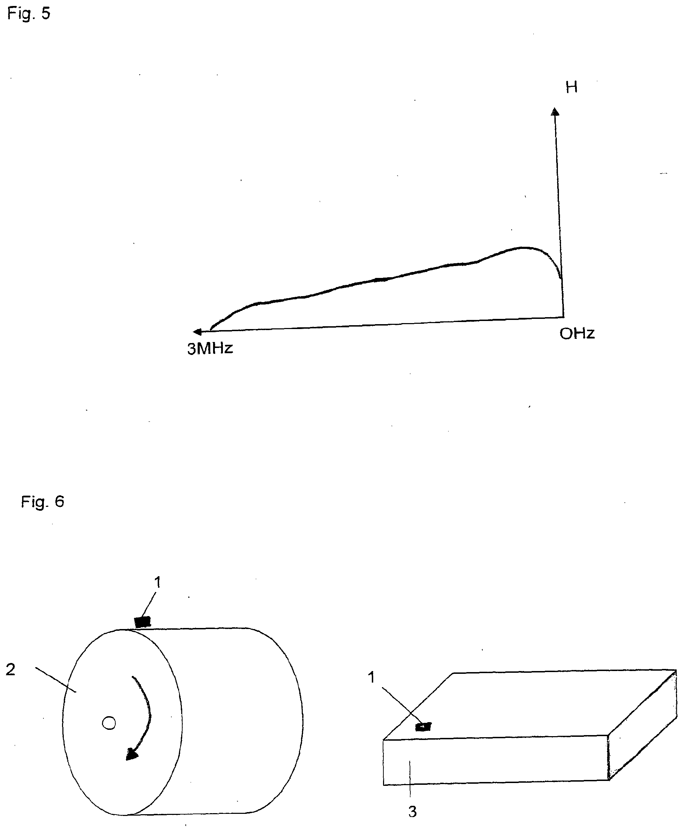

Fig. 5 zeigt die Hauptemissionen mit Projektion auf die Frequenzachse.

Bei einer nicht erfindungsgemäßen elektrischen oder magnetischen Anregung wird die Frequenz der Anregung variiert oder je nach Auswerteziel unterschiedlich gewählt. Bei hoher Frequenz ist die Eindringtiefe in das Material geringer als bei niedriger Frequenz. Insofern kann es zweckmäßig sein, bei der Anregung einen Frequenzbereich zu durchqueren, um Materialeigenschaften abhängig von der Tiefe des Materials zu erfassen.

Beispielsweise kann im in Fig. 6 dargestellten Ausführungsbeispiel mittels eines Magnetfeldsensors 1 die Oberfläche eines rotierenden Rades 2, z.B. eines Radreifens eines Zuges, oder eines flächigen Materials 3, z.B. einer Platte, abgetastet werden unter Erstellung eines Materialeigenschaftsprofils, insbesondere Härte- oder Festigkeitsprofils, der jeweiligen Oberfläche, wobei vorteilhafterweise die Materialeigenschaft als Funktion des Abstands von der Oberfläche erfassbar sein kann.

Das Verfahren ist auch bei der Beurteilung von Schweißnähten nutzbar. So kann beim Abtasten der Schweißnaht ein insbesondere tiefenabgestufter Rückschluss auf die Qualität der Scheißnaht, die Festigkeit etc. erhalten werden und Defekte wie etwa Risse sind erkennbar.

Besonders vorteilhaft einsetzbar sind die erfindungsgemäßen Verfahren, Vorrichtungen und Verwendungen beim Prozessmonitoring.

Beispielsweise kann beim Drahtziehen Draht 4, der entlang eines Pfeils 5 aus einer Drahtziehvorrichtung gezogen wird, an einem Magnetfeldsensor 6 oder mehreren Magnetfeldsensoren 6' entlang bewegt werden unter Erfassung eines Magnetfelds des vom Magnetfeldsensor erfassten Materialvolumens. Die Anregung erfolgt zweckmäßigerweise durch eine Vorrichtung 7 z.B. in Form einer Magnetisierung 8. Eine in Zugrichtung 5 nachgelagerte Vorrichtung 7' kann für eine Entmagnetisierung 8' vorgesehen sein.

Anstelle des Drahts 4 kann auch ein flächiges Material, z.B. ein Blech 4, am Magnetfeldsensor 6 vorbeigeführt werden.

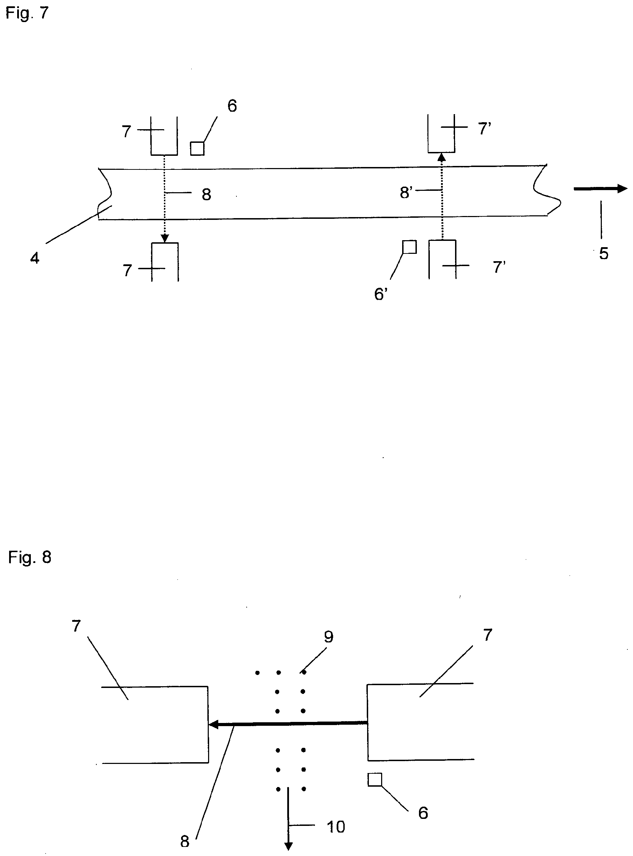

Schüttgut 9, etwa Schrauben, können durch eine Vorrichtung 7 entlang eines Pfeils 10 der Schwerkraft folgend fallen und dabei von einem Magnetfeldsensor 6 erfasst werden, siehe Fig. 8.

Vorrichtung(en) 7, 7'... und Magnetfeldsensor(en) 6, 6'... können allgemein entlang beliebiger Materialwege angeordnet werden.

Diesen Varianten des Prozessmonitoring ist gemein, dass bei stationärer Magnetfeldsensoranordnung ein kontinuierlicher Materialfluss die im wesentlichen vollständige Prüfung ermöglicht. Härte, Dichteschwankungen des Materials, Oberflächenwelligkeiten, Drahtdurchmesser und dergleichen sind erfassbar.

Die Anregung, die in den vorgenannten Beispielen bevorzugt magnetisch und/oder elektrisch erfolgt, wird erfindungsgemäß mechanisch oder thermisch durchgeführt.

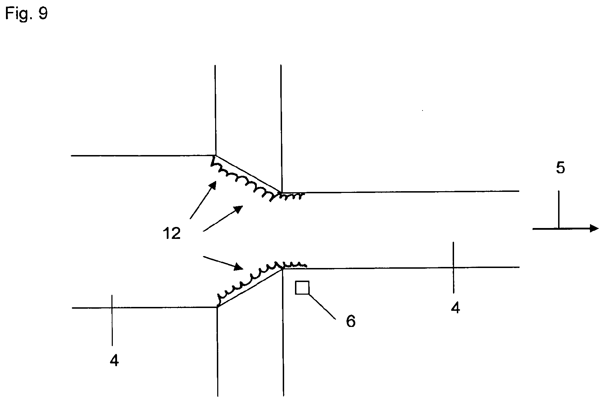

So bewirkt eine mechanische Einwirkung auf ein Werkstück, insbesondere eine plastische und/oder elastische Umformung oder eine spanende Bearbeitung und dergleichen, eine erfassbare Magnetfeldänderung, insbesondere bei ferro- oder paramagnetischem oder metallischem Material. Beispielhaft in Fig. 9 dargestellt ist eine Drahtzugvorrichtung 11 mit plastischer und ggf. elastischer Umformung 12 und einem Magnetfeldsensor 6. Durch die erfindungsgemäße Erfassung und Auswertung des infolge der Umformung 12 entstehenden Magnetfelds ist die Qualität der Umformung erfassbar. Auch sind Dickenvariationen, Oberflächenwellen oder Fehler sowie der Drahtabriss, und dergleichen mehr, feststellbar.

Alle Ausführungsformen der Erfindung sind bevorzugt mit ferromagnetischem Material, aber auch mit paramagnetischem Material oder mit nicht magnetischem Material verwendbar. Ist beispielsweise die Platte 4 in Fig. 7 aus Kunststoff, kann über die Vorrichtung 7 und den Sensor 6 kraft Dämpfungsverhalten der Platte 4 Rückschluss auf die Platte 4 hinsichtlich Dicke, Defekte wie Löcher oder Materialeinschlüsse oder Dichtevariationen oder Risse oder dergleichen, Oberflächenwelligkeiten usw. erhalten werden. Bei modernen Verbundkunstoffen oder mit Partikeln versetzten Kunststoffen ist die Erfindung ebenfalls verwenbar. Hier kann beispielsweise die Partikeldichte, die Gleichmäßigkeit der Partikelverteilung, die Qualität des Verbunds überwacht sowie Fehler wie etwa fehlerhafte Verbindungen und Ablösungen bei flächigen Verbundstoffen oder Einschlüsse oder dergleichen erkannt werden.

Eine weitere Verwendung ist das Prozessmonitoring beim Härten, insbesondere Presshärten. Als Anregung dient dabei die Umformung und/oder Erhitzung des Materials. Das Magnetfeld ändert sich während des Abkühlens bzw. während des Umformens und nach dem Umformen. Durch Erfassen des Magnetfelds können die Kristallisierungsvorgänge beobachtet und ausgewertet werden. Rückschlüsse auf den Kristallisationsgrad und die Gefügestruktur sind möglich oder es kann der Zeitpunkt erfasst werden, bei dem das Material aus der Form lösbar ist, weil der Härteprozess abgeschlossen ist. Darüber hinaus sind die bereits erwähnten Informationen erhältlich wie Fehler (Rissbildung beim Abkühlen, auch betreffend Mikrosisse, Brüche etc.) und es ist eine Prozessoptimierung möglich durch Erfassung der Materialparameter während einer Variation der Prozessparameter Temperatur, Umformdruck, Erhitzungsgeschwindigkeit, Abkühlgeschwindigkeit, Temperaturprofil als Funktion der Zeit, Umformgeschwindigkeit oder -profil etc.

Auswertetechnisch sieht die Erfindung bevorzugt vor, mit Kennwertvektoren zu arbeiten. Ein Kennwertvektor ist dabei ein n-Tupel aus einzelnen Werten wie Frequenzverteilung, Einfach- oder Mehrfachpeaks, Steigung der Peaks, Magnetfeld etc. Ein derartiger Kennwertvektor kann als Muster aufgenommen werden für bekannte Eigenschaften und anschließend verglichen werden mit bei der Prüfung erfassten Kennwertvektoren zwecks Bestimmung von Material- und/oder Prozesseigenschaften.

## Patentansprüche

1. Verfahren zum Beobachten eines Magnetfelds eines Materialvolumens zur Bestimmung von Eigenschaften eines Werkstücks unter Anregung eines Materialvolumens des Werkstücks, umfassend eine Erfassung des Magnetfelds des Materialvolumens als Funktion der Zeit und der Frequenz mit einer hochfrequenten Auflösung, **gekennzeichnet durch** eine mechanische und/oder thermische Anregung.

2. Verfahren nach Anspruch 1, **dadurch gekennzeichnet, dass** die Frequenz- und/oder Zeitauflösung der Erfassung entsprechend der mikromagnetischen Effekte im Materialvolumen gewählt wird.

3. Verfahren nach Anspruch 1 oder 2, **dadurch gekennzeichnet, dass** die Geschwindigkeit der Reaktion auf die Anregung erfasst wird.

4. Verfahren nach einem der Ansprüche 1 bis 3, **gekennzeichnet durch** eine magnetische und/oder elektrische Anregung und/oder **dadurch, dass** die Anregung mit einem magnetischen und/oder elektrischen Wechselfeld und/oder statischem Feld und/oder mittels Wirbelstrominduktion und/oder durch eine Materialverarbeitung wie etwa Induktionshärten und/oder durch Anlegen eines Wechsel- oder Gleichstroms und/oder Anlegen einer Wechsel- und/oder Gleichspannung und/oder durch Materialverformung erfolgt.

5. Verfahren nach Anspruch 4, **dadurch gekennzeichnet, dass** ein ferromagnetisches Werkstück unter magnetischer Anregung verwendet wird und das Magnetfeld während des Durchlaufens einer Hälfte der Hysteresekurve, einer vollständigen Hysteresekurve oder mehrerer aufeinanderfolgender Hysteresekurven erfasst wird.

6. Verfahren nach einem der Ansprüche 1 bis 5, **dadurch gekennzeichnet, dass** das Material bei der Anregung und/oder dem Erfassen relativ zu einem Sensor und/oder einer Anregevorrichtung ortsfest ist.

7. Verfahren nach einem der Ansprüche 1 bis 5, **dadurch gekennzeichnet, dass** das Material bei der Anregung und/oder dem Erfassen relativ zu einem Sensor und/oder einer Anregevorrichtung verfahren wird.

8. Verfahren nach einem der Ansprüche 1 bis 7, **dadurch gekennzeichnet, dass** die Frequenz der anregenden Quelle variiert, insbesondere ein Frequenzbereich durchfahren wird.

9. Verfahren nach einem der Ansprüche 1 bis 8, **dadurch gekennzeichnet, dass** mehrere Anregevorrichtungen und/oder mehrere Magnetfeldsensoren verwendet werden.

10. Vorrichtung zum Beobachten eines Magnetfelds eines Materialvolumens zur Bestimmung von Eigenschaften eines Werkstücks unter Anregung eines Materialvolumens des Werkstücks, umfassend einen Sensor zum Erfassen des Magnetfelds des Materialvolumens als Funktion der Zeit und der Frequenz mit einer hochfrequenten Auflösung, **gekennzeichnet durch** eine Anregevorrichtung zur mechanischen und/oder thermischen Anregung des Werkstücks oder eines Materialvolumens des Werkstücks.

11. Vorrichtung nach Anspruch 10, **gekennzeichnet durch** eine Anregevorrichtung zur magnetischen und/oder elektrischen Anregung des Werkstücks oder eines Materialvolumens des Werkstücks.

12. Vorrichtung nach Anspruch 10 oder 11, **gekennzeichnet durch** eine Auswerteeinrichtung zum dreidimensionalen Auswerten des Magnetfelds im Frequenz-Zeit-Spektrum.

13. Verwendung der Vorrichtung nach einem der Ansprüche 10 bis 12 zum Prozessmonitoring, insbesondere zur Prüfung eines kontinuierlich zugeführten und/oder hergestellten drahtförmigen oder flächigen Materials oder von Schüttgut, insbesondere beim Drahtziehen.

14. Verwendung der Vorrichtung nach einem der Ansprüche 10 bis 12 zum Messen des Härte- und/oder Festigkeitsprofils einer Oberfläche, insbesondere einer Oberfläche eines Werkstücks mit kreisförmigem Durchmesser oder einer Schweißnaht.

15. Verfahren, Vorrichtung oder Verwendung nach einem der vorhergehenden Ansprüche, **gekennzeichnet durch** eine Korrelation der erfassten Signalform mit einer Materialeigenschaft wie etwa Härte, Eigenspannung, Gefügestruktur, Legierungsbestandteile.

## Claims

1. A method for monitoring a magnetic field of a material volume for the determination of properties of a workpiece by exciting a material volume of the workpiece, comprising detection of the magnetic field of the material volume as a function of time and frequency with a high-frequency resolution, **characterised by** a mechanical and/or thermal excitation.

2. The method according to claim 1, **characterised in that** the frequency and/or time resolution of the detection is selected corresponding to the micromagnetic effects in the material volume.

3. The method according to claim 1 or 2, **characterised in that** the speed of the reaction to the excitement is detected.

4. The method according to any one of claims 1 to 3, **characterised by** a magnetic and/or electrical excitation and/or by the fact that the excitation takes place with a magnetic and/or electrical alternating field and/or static field and/or by means of eddy current induction and/or by material processing such as for example induction hardening and/or by applying an alternating or direct current and/or applying an alternating and/or direct voltage and/or by material deformation.

5. The method according to claim 4, **characterised in that** a ferromagnetic workpiece is used under magnetic excitation and the magnetic field is detected during the passage of one half of the hysteresis curve, a complete hysteresis curve or a plurality of successive hysteresis curves.

6. The method according to any one of claims 1 to 5, **characterised in that** the material is stationary relative to the sensor and/or excitation device during the excitation and/or the detection.

7. The method according to any one of claims 1 to 5, **characterised in that** the material is moved relative to the sensor and/or the excitation device during the excitation and/or the detection.

8. The method according to any of claims 1 to 7, **characterised in that** the frequency of the exciting source varies, in particular a frequency range is passed through.

9. The method according to any one of claims 1 to 8, **characterised in that** a plurality of excitation devices and/or a plurality of magnetic field sensors are used.

10. An apparatus for observing a magnetic field of a material volume for the determination of properties of a workpiece by exciting a material volume of the workpiece, comprising a sensor for detecting the magnetic field of the material volume as a function of time and frequency with a high-frequency resolution, **characterised by** an excitation device for the mechanical and/or thermal excitation of the workpiece or a material volume of the workpiece.

11. The apparatus according to claim 10, **characterised by** an excitation device for the magnetic and/or electrical excitation of the workpiece or a material volume of the workpiece.

12. The apparatus according to claim 10 or 11, **characterised by** an evaluation device for the three-dimensional evaluation of the magnetic field in the frequency-time spectrum.

13. Use of the apparatus according to any one of claims 10 to 12 for process monitoring, in particular for testing a continuously fed and/or produced wire-shaped or flat material or bulk material, in particular during wire drawing.

14. The use of the apparatus according to any one of claims 10 to 12 for measuring the hardness and/or strength profile of a surface, in particular a surface of a workpiece with a circular diameter or a weld seam.

15. Method, apparatus or use according to any one of the preceding claims, **characterised by** a correlation of the detected waveform with a material property such as for example hardness, residual stress, microstructure, alloying constituents.

## Revendications

1. Méthode de surveillance d'un champ magnétique d'un volume de matériau pour déterminer des propriétés d'une pièce en excitant un volume de matériau de la pièce, comprenant une saisie du champ magnétique du volume de matériau sous la forme d'une fonction de temps et de fréquence avec une résolution à haute fréquence, **caractérisée par** une excitation mécanisme et/ou thermique.

2. Méthode selon la revendication 1, **caractérisée en ce que** la résolution de fréquence et/ou de temps de la saisie est choisie selon les effets micromagnétiques dans le volume de matériau.

3. Méthode selon la revendication 1 ou 2, **caractérisée en ce que** la vitesse de réaction à l'excitation est saisie.

4. Méthode selon l'une quelconque des revendications 1 à 3, **caractérisée par** une excitation magnétique et/ou électrique et/ou en ce que l'excitation a lieu avec un champ alternatif magnétique et/ou électrique et/ou un champ statique et/ou au moyen d'une induction à courant de Foucault et/ou par application d'un courant alternatif ou continu et/ou application d'une tension alternative et/ou continue par déformation de matériau.

5. Méthode selon la revendication 4, **caractérisée en ce qu'**une pièce ferromagnétique sous excitation magnétique est utilisée et le champ magnétique est saisi pendant le passage d'une moitié de la courbe d'hystérésis, d'une courbe d'hystérésis complète ou de plusieurs courbes d'hystérésis successives.

6. Méthode selon l'une quelconque des revendications 1 à 5, **caractérisée en ce que** le matériau est fixe lors de l'excitation et/ou de la saisie par rapport à un capteur et/ou un dispositif d'excitation.

7. Méthode selon l'une quelconque des revendications 1 à 5, **caractérisée en ce que** le matériau est déplacé lors de l'excitation et/ou de la saisie par rapport à un capteur et/ou un dispositif d'excitation.

8. Méthode selon l'une quelconque des revendications 1 à 7, **caractérisée en ce que** la fréquence de la source excitante varie, en particulier une plage de fréquences est traversée.

9. Méthode selon l'une quelconque des revendications 1 à 8, **caractérisée en ce que** plusieurs dispositifs d'excitation et/ou plusieurs capteurs de champ magnétique sont utilisés.

10. Appareil de surveillance d'un champ magnétique d'un volume de matériau pour la détermination des propriétés d'une pièce en excitant un volume de matériau de la pièce comprenant un capteur pour la saisie du champ magnétique du volume de matériau sous la forme d'une fonction de temps et de fréquence avec une résolution à haute fréquence, **caractérisé par** un dispositif d'excitation pour l'excitation mécanique et/ou thermique de la pièce ou d'un volume de matériau de la pièce.

11. Appareil selon la revendication 10, **caractérisé par** un dispositif d'excitation pour l'excitation magnétique et/ou électrique de la pièce ou d'un volume de matériau de la pièce.

12. Appareil selon la revendication 10 ou 11, **caractérisé par** un système d'évaluation pour l'évaluation tridimensionnelle du champ magnétique dans un spectre fréquence-temps.

13. Utilisation de l'appareil selon l'une quelconque des revendications 10 à 12 pour la télésurveillance de processus, en particulier pour le contrôle d'un matériau en forme de fil ou plan alimenté et/ou fabriqué en continu ou de matériau en vrac, en particulier pour le tréfilage.

14. Utilisation de l'appareil selon l'une quelconque des revendications 10 à 12 pour la mesure du profil de dureté et/ou de résistance d'une surface, en particulier d'une surface d'une pièce avec un diamètre circulaire ou d'un cordon de soudure.

15. Méthode, appareil ou utilisation selon l'une quelconque des revendications précédentes, **caractérisés par** une corrélation de la forme de signal saisie avec une propriété de matériau comme par exemple la dureté, une contrainte propre, une constitution structurale, des composants d'alliage.
